Europäisches Patentamt

European Patent Office

Office européen des brevets

(19)

(11) Veröffentlichungsnummer : **0 063 819**
**B1**

(12) **EUROPÄISCHE PATENTSCHRIFT**

(45) Veröffentlichungstag der Patentschrift :
28.08.85

(21) Anmeldenummer : 82103577.1

(22) Anmeldetag : 27.04.82

(51) Int. Cl.⁴ : **H 03 D   7/14,** H 03 D   9/06

(54) **Mikrowellen-Gegentaktmischerschaltung in Streifenleitungstechnik.**

(30) Priorität : 29.04.81 DE 3117080

(43) Veröffentlichungstag der Anmeldung :
03.11.82 Patentblatt 82/44

(45) Bekanntmachung des Hinweises auf die Patenterteilung : 28.08.85 Patentblatt 85/35

(84) Benannte Vertragsstaaten :
**BE DE FR GB IT NL**

(56) Entgegenhaltungen :
DE-A- 2 944 642
DE-B- 2 342 671
DE-B- 2 454 058
DE-B- 2 539 611
US-A- 3 659 206
US-A- 3 870 960
Patent Abstracts of Japan Band 5, Nr. 133, 25.08.1981
(73) Patentinhaber : **Siemens Aktiengesellschaft
Berlin und München Wittelsbacherplatz 2
D-8000 München 2 (DE)**

(72) Erfinder : **Sedlmair, Siegfried, Dipl.-Ing.
Mittenwalder Strasse 147
D-8038 Gröbenzell (DE)**

Jouve, 18, rue St-Denis, 75001 Paris, France

## Beschreibung

Die Erfindung bezieht sich auf eine Mikrowellen-Gegentaktmischerschaltung in Streifenleitungstechnik mit einem Differentialübertrager, der zum Anlegen zweier zu mischender Eingangsspannungen zwei Eingangsanschlüsse aufweist, von denen der erste zur gleichphasigen Aufteilung der ihm zugeführten Eingangsspannung (HF-Eingangssignal) auf zwei Übertrager-Ausgangsanschlüsse über zwei Viertelwellenlängen-Streifenleitungen mit den beiden Übertrager-Ausgangsanschlüssen und von denen der zweite zur gegenphasigen Aufteilung der ihm zugeführten Eingangsspannung (Oszillatorsignal) über geeignete Leitungsverbindungen ebenfalls mit den beiden Übertrager-Ausgangsanschlüssen verbunden ist, an die jeweils über einen von zwei symmetrischen Streifenleitern an einer verbreiterten und damit eine Parallelkapazität bildenden Anschlußstelle jeweils eine von zwei Halbleiterdioden angeschlossen ist, die mit ihrem anderen Anschluß an einer gemeinsamen, vor einem Zwischenfrequenzsignalausgang liegenden Anschlußstelle zusammengeschaltet sind, allerdings mit unterschiedlicher Polung zum Zwischenfrequenzsignalausgang hin, vor dem im Anschluß an die gemeinsame Diodenanschlußstelle noch eine Einrichtung zur Abblockung des Frequenzbereichs der beiden Eingangsspannungen vorgesehen ist, die aus Streifenleiterstücken und/oder konzentrierten Bauelementen besteht und so dimensioniert ist, daß sich bei der gewünschten Zwischenfrequenz am Zwischenfrequenzsignalausgang ein Widerstandswert $Z_0$ ergibt.

Wenn das Problem besteht, einen Mischer zu realisieren, der auch mit stärker rauschenden Oszillatoren betrieben werden kann, ohne daß sich die Mischerrauschzahl merklich verschlechtert, und der außerdem geringe Mischverluste haben soll, so wird vorteilhaft von einem Gegentaktmischer Gebrauch gemacht, der mit breitbandiger hoher Isolation zwischen den beiden Eingangsanschlüssen, d. h. zwischen dem Oszillator- und dem Eingangssignalarm, sowie mit guter Anpassung sowohl der beiden Eingangssignalanschlüsse als auch des Zwischenfrequenzsignalausgangs z. B. an einen Wellenwiderstand $Z_0$ von 50 Ω arbeitet.

Es sind Gegentaktmischerschaltungen bekannt, die eingangsseitig für die entkoppelte Zuführung der beiden Eingangssignale einen Differentialübertrager aufweisen, der als 90°-Ringhybrid oder als 180°-Ringhybrid ausgebildet ist (US-A-3 659 206). Hierbei ist zwar die Entkopplung im allgemeinen ausreichend, aber die Bandbreiteanforderungen und das häufig auftretende Bedürfnis der Unterdrückung des Oszillatorrauschens, insbesondere wenn die Signal- und die Oszillatorfrequenz einen größeren Abstand voneinander haben, werden nicht zufriedenstellend erfüllt.

Aus DE-A-2 944 642 ist ein Gegentaktmischer in Streifenleitungstechnik bekannt, der eine andere Eingangsschaltung für die beiden Eingangssignalspannungen aufweist, d. h. kein Hybrid und keinen Differentialübertrager. Es werden mit dieser Schaltung zwar einige Nachteile der Gegentaktmischer mit Ringhybrid vermieden, wofür aber der schwerwiegende Nachteil einer sehr schlechten gegenseitigen Entkopplung der beiden Eingangssignale in Kauf genommen werden muß.

Aufgabe der Erfindung ist es, einen Gegentaktmischer in Streifenleitungstechnik so auszubilden, daß bei hoher, frequenzunabhängiger gegenseitiger Entkopplung der beiden Eingangssignale und auch des Zwischenfrequenz-Ausgangssignals eine starke Unterdrückung des Oszillatorrauschens auch bei großem Abstand zwischen Signal- und Oszillatorfrequenz erreicht wird, wobei einwandfreie Anpassung sowohl an den beiden Eingangssignalanschlüssen als auch am Zwischenfrequenzsignalausgang an den bestehenden Wellenwiderstandswert $Z_0$ herrscht.

Gemäß der Erfindung, die sich auf eine Gegentakt-Mischerschaltung der eingangs genannten Art bezieht, wird diese Aufgabe dadurch gelöst, daß die Leitungsverbindungen im Differentialübertrager zur gegenphasigen Aufteilung der dem zweiten Eingangsanschluß zugeführten Eingangsspannung so ausgebildet sind, daß der zweite Eingangsanschluß mit dem einen Übertrager-Ausgangsanschluß über den Innenleiter einer bogenförmig verlaufenden, koaxialen Leitung verbunden ist, zu der symmetrisch, ausgehend von diesem Übertrager-Ausgangsanschluß ein bogenförmig verlaufender Streifenleiter mit Durchkontaktierung zur Masseplatte am Ende angeordnet ist und deren eines Außenleiterende zur Masseplatte durchkontaktiert und deren anderes Außenleiterende am anderen Übertrager-Ausgangsanschluß angeschlossen ist, daß die bogenförmige koaxiale Leitung und der dazu symmetrisch verlaufende Streifenleiter, die von den beiden Differentialübertrager-Ausgangsanschlüssen abgehen, kürzer ausgebildet sind als eine Viertelwellenlänge, so daß sich Parallelinduktivitäten ergeben, daß die beiden symmetrischen Streifenleiter zwischen den beiden Übertrager-Ausgangsanschlüssen und den beiden Diodenanschlußstellen, die verbreiterten Diodenanschlußstellen selbst und die bogenförmig verlaufende koaxiale Leitung sowie der dazu symmetrisch bogenförmige Streifenleiter des Differentialübertragers so bemessen sind, daß die Diodenimpedanzen an den Differentialübertrager-Ausgangsanschlüssen jeweils auf den Widerstandswert $Z_0$ transformiert werden, daß die Breite der beiden vom ersten Eingangsanschluß ausgehenden Viertelwellenlängen-Streifenleiter des Differentialübertragers so bemessen ist, daß sich jeweils ein Wellenwiderstandswert $Z_0 \cdot \sqrt{2}$ ergibt, und daß zwischen dem den Differentialübertrager-Ausgangsanschlüssen abgekehrten Innenleiterende der koaxialen Leitung und dem zugehörigen Eingangsanschluß ein Streifenleiter eingefügt ist, so daß die Gesamtlänge der koaxialen Leitung und dieses Streifenleiters eine Viertelwellenlänge und der Wellenwiderstandswert dieser beiden Leitungen $Z_0 \cdot \sqrt{2}$ beträgt.

Die Erfindung und Weiterbildungen davon werden im folgenden anhand von drei Figuren näher erläutert. Es zeigen

Figur 1 in einer Seitenansicht und in einer Draufsicht eine Gesamtanordnung eines ausgeführten Gegentaktmischers nach der Erfindung,

Figur 2 eine andere Ausführung eines Gegentaktmischers nach der Erfindung,

Figur 3 ein drittes Ausführungsbeispiel eines Gegentaktmischers nach der Erfindung für eine höhere Betriebsfrequenz.

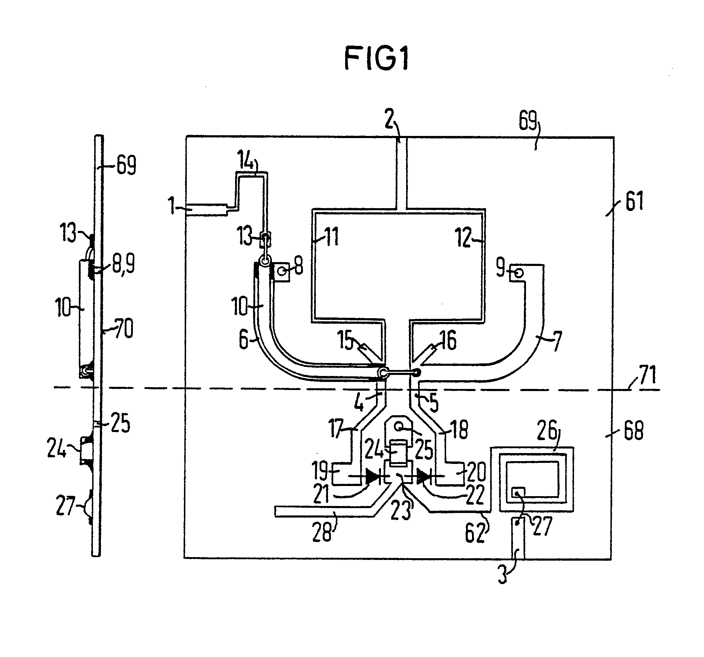

Fig. 1 zeigt links in einer Seitenansicht und rechts in einer Draufsicht die vergrößerte Gesamtanordnung eines ersten Ausführungsbeispiels eines Gegentaktmischers nach der Erfindung in Streifenleitungstechnik auf einer Keramiksubstratplatte 69 mit einer leitenden, durchgehenden Masseschicht 70 für eine Betriebsfrequenz von etwa 1 GHz und eine Zwischenfrequenz von etwa 60 MHz. Ein Differentialübertrager 61 befindet sich auf der Platte 69 oberhalb einer gestrichelten Linie 71. Der darunter liegende Teil 68 ergänzt den Differentialübertrager 61 zum Gegentaktmischer. Der Differentialübertrager 61 hat die Aufgabe, ein in einen Anschluß 1 eingespeistes Signal (Oszillatorsignal) in Gegenphase und ein in einen Anschluß 2 eingespeistes Signal (Eingangssignal) in Gleichphase je zur Hälfte an zwei Anschlüsse 4 und 5 zu leiten. Bei einer symmetrischen Beschaltung der beiden Anschlüsse 4 und 5 sind die Signalanschlüsse 1 und 2 frequenzunabhängig entkoppelt. Die gleichphasige Aufteilung erfolgt durch zwei Streifenleiter 11 und 12, die etwa eine Viertelwellenlänge lang sind. Die gegenphasige Aufteilung wird unter Zuhilfenahme einer dünnen Koaxialleitung 10 erreicht, die auf einem Streifenleiter 6 aufgebracht ist, der etwa eine Viertelwellenlänge lang ist und an einem Ende mittels einer Durchkontaktierung 8 des Außenleiters zur Masseplatte 70 kurzgeschlossen ist. Der Außenleiter der koaxialen Leitung 10 endet am Anschluß 4 und der Innenleiter dieser koaxialen Leitung 10 am Anschluß 5, der zur Symmetrierung auf einen Streifenleiter 7 mit einer Durchkontaktierung 9 zur Masseplatte 70 führt. Die koaxiale Leitung 10 ist außen an jeder Stelle potentialgleich mit dem Streifenleiter 6, in vorteilhafter Weise aber nur an ihren Enden elektrisch und mechanisch z. B. durch Lötung mit dem Streifenleiter 6 verbunden. Wärmeausdehnungsunterschiede zwischen der koaxialen Leitung 10 und dem Streifenleiter 6 können durch die Bogenführung dann nicht zu großen mechanischen Spannungen führen.

Der Durchmesser der koaxialen Leitung 10 darf höchstens gleich der Breite des Streifenleiters 6 gemacht werden, wenn ohne Korrekturmaßnahmen eine Entkopplung von etwa 30 dB erreicht werden soll. Breitere koaxiale Leitungen 10 erniedrigen den Wellenwiderstand der Leitung mit dem Streifenleiter 6, so daß, um wieder Symmetrie zu erreichen, die Leitung mit dem Streifenleiter 7 den gleichen Wellenwiderstand bekommen, also verbreitert werden muß. Es genügt zur Symmetrierung aber auch eine Parallelkapazität am Anschluß 5, indem man etwa eine Abgleichkapazität, die durch ein Streifenleiterstück 16 am Anschluß 5 realisiert ist, größer macht als eine Abgleichkapazität, die durch ein vom Anschluß 4 ausgehendes Streifenleiterstück 15 gebildet wird.

Zwischen zwei Halbleiterdioden 21 und 22 und dem Differentialübertrager 61 ist eine Anpaßschaltung eingefügt, die gewährleistet, daß die beiden Eingangssignalleistungen, d. h. sowohl die dem Anschluß 1 zugeführte Oszillatorleistung als auch die dem Eingang 2 zugeführte Signalleistung möglichst voll genutzt werden. Die Impedanz der beiden Dioden 21 bzw. 22 wird durch eine Parallelkapazität 19 bzw. 20, einen Streifenleiter 17 bzw. 18 und eine Parallelinduktivität am Anschluß 4 bzw. 5 auf den Widerstand $Z_0$ transformiert. Der Widerstand $Z_0$ ist derjenige Widerstand, der an den Eingangsanschlüssen 1 und 2 sowie an einem Zwischenfrequenzsignalausgang 3 bestehen soll und beträgt beispielsweise 50 Ω. Die beiden genannten Parallelkapazitäten 19 und 20 werden durch Vergrößerungen der Streifenleiterbreite an den Anschlußstellen der beiden Dioden 21 und 22 realisiert. Die genannte Parallelinduktivität wird dadurch gebildet, daß die beiden Streifenleiter 6 und 7 des Differentialübertragers 61 kürzer als eine Viertelwellenlänge ausgeführt werden. Diese Art der Anpassung ergibt einen geringen Platzbedarf, der vor allem bei relativ niedrigen Mikrowellenfrequenzen, wie etwa 1 GHz, von Vorteil ist. Der Differentialübertrager 61 wird somit zu einem Teil der Anpaßschaltung. Seine mit den beiden Streifenleitern 6 und 7 gebildeten Leitungen stellen außerdem den für die beiden Mischerdioden 21 und 22 erforderlichen Gleichstromrückweg dar. Die weitere Anpassung innerhalb des Differentialübertragers 61 an den äußeren Signalanschluß 2 auf den Wellenwiderstand $Z_0$ von beispielsweise 50 Ω erfolgt nun so, daß die beiden eine Viertelwellenlänge langen Leitungen mit den Streifenleitern 11 bzw. 12 mit einem Wellenwiderstand von $Z_0 \cdot \sqrt{2}$ ausgeführt sind. Der Anschlußwert für die koaxiale Leitung 10 zwischen den beiden Anschlüssen 4 und 5 beträgt $2 \cdot Z_0$, also beispielsweise 100 Ω. Dieser Wert wird über einen Leitungstransformator, der eine Viertelwellenlänge lang ist und einen Wellenwiderstand von ebenfalls $Z_0 \cdot \sqrt{2}$ aufweist, auf den Widerstand $Z_0$ nach dem Eingangsanschluß 1 transformiert. Dieser Viertelwellenlängen-Transformator besteht hier aus zwei Teilstücken, da die Länge der koaxialen Leitung 10 in zweckmäßiger Weise nur so lang wie der Streifenleiter 6 gemacht ist. Ein Streifenleiter 14 der an einer Verbindungsstelle 13 mit dem Innenleiter der koaxialen Leitung 10 verbunden ist, ergänzt die Gesamtleitungslänge, d. h. die Summe der koaxialen Leitung 10 und der Streifenleitung 14, auf eine Viertelwellenlänge. Die Streifenleitung 14 hat auch den Wellenwiderstand $Z_0 \cdot \sqrt{2}$. Als koaxiale Leitung 10 kann beispielsweise Semirigidkabel verwendet werden.

Die in Fig. 1 gezeigte Anordnung zeigt eine besondere hochfrequenzmäßige Abblockung zwischen den Mischerdioden 21, 22 und dem Zwischenfrequenzsignalausgang 3. Auch beim Zwischenfrequenzsignalausgang 3 soll genauso wie bei den Signalausgängen 1 und 2 Anpassung auf den Widerstand $Z_0$ bestehen. Der Kapazitätswert eines Abblockkondensators 24 ist deshalb so gewählt, daß sich zusammen mit der Induktivität einer integrierten Streifenleiterspule 26 bei der gewünschten Zwischenfrequenz von z. B. 60 MHz am Zwischenfrequenzsignalausgang 3 Anpassung an den Widerstand $Z_0$ ergibt. Diese einfache Art der Anpassung ist zwar nicht sehr breitbandig, in sehr vielen Fällen jedoch ausreichend. Auf mögliche Breitbandschaltungen mit vier Blindelementen soll nur hingewiesen werden.

Die hochfrequenzmäßige Abblockung ist dadurch sehr wirksam gemacht, daß die ohnehin vorhandene Serienresonanz, die sich aus der Abblockkapazität 24 und ihrer Zuleitungsinduktivität einschließlich der Induktivität einer Durchkontaktierung 25 nach Masse ergibt, in die Gegend der Signal- bzw. Oszillatorfrequenz gelegt wird. Dies läßt sich beispielsweise dadurch bewerkstelligen, daß man den Abstand zwischen dem gemeinsamen Diodenanschlußpunkt 23 und der Durchkontaktierungsstelle 25 geeignet wählt.

Die Streifenleiterspule 26 ist auf der einen Seite über einen schmalen Streifenleiter 62 mit dem gemeinsamen Diodenanschlußpunkt 23 und auf der anderen Seite über eine Drahtbrücke 27 mit dem Zwischenfrequenzsignalausgang 3 verbunden.

Eine vorteilhafte Maßnahme, die zu geringen Mischverlusten führt, besteht darin, für die Summenfrequenz der beiden Eingangssignale einen hochfrequenzmäßigen Kurzschluß am Diodenzusammenschaltpunkt 23 zu schaffen. Dies wird mit einem am Ende leerlaufenden, für die Summenfrequenz eine Viertelwellenlänge langen Streifenleiter 28 erreicht. Bei der Zwischenfrequenz schaltet sich die Kapazität der Leitung mit dem Streifenleiter 28 zur Abblockkapazität 24 parallel.

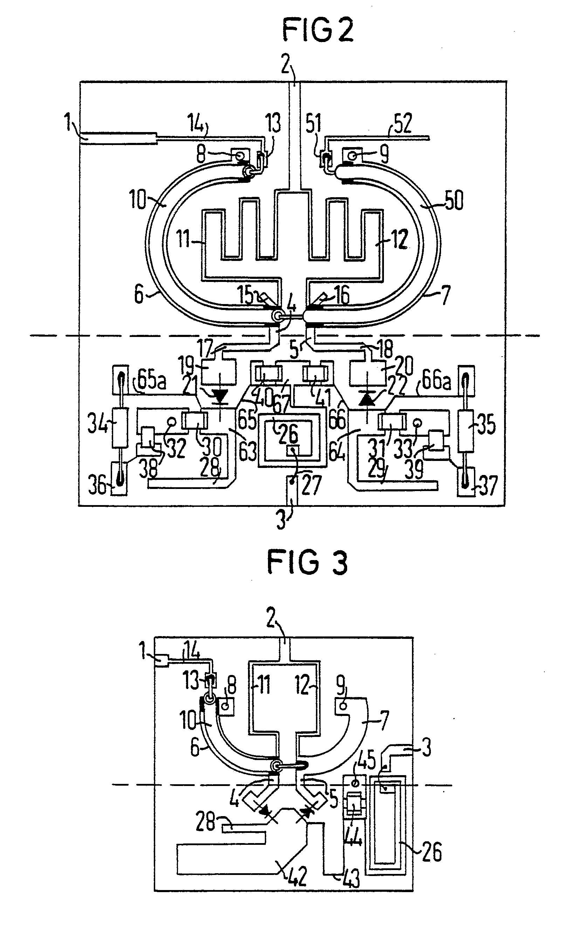

Fig. 2 zeigt in einer vergrößerten Draufsicht, eine andere Ausführungsform eines Streifenleitungs-Gegentaktmischers nach der Erfindung. Eine etwas andere Ausführung des Diodenteils gestattet es, die von den Mischerdioden 21 und 22 gleichgerichtete Oszillatorspannung zu Kontrollzwecken herauszuführen oder eine Vorspannung zuzuführen. Die hochfrequenzmäßige Verblockung erfolgt über zwei Abblockkondensatoren 30 und 31, die sich beispielsweise bezüglich der Eingangssignalfrequenzen in Serienresonanz mit den Induktivitäten der beiden Durchkontaktierungen 32 bzw. 33 befinden. Der Kurzschluß für die Summenfrequenz der beiden an den Eingangsanschlüssen 1 und 2 zugeführten Eingangsspannungen erfolgt mittels der beiden leerlaufenden Streifenleiter 28 und 29. Der Gleichstromanteil nach den Dioden 21 und 22 gelangt über zwei Drosseln 34 und 35 zu den beiden Anschlußpunkten 36 bzw. 37. Diese beiden Anschlußpunkte 36 und 37 sind jeweils über einen der beiden Widerstände 38 und 39 an den Durchkontaktierungen 32 und 33 mit Masse verbunden, um den Gleichstromweg für die Dioden 21 bzw. 22 zu schließen, wenn keine niederohmige äußere Beschaltung erfolgt. Das Zwischenfrequenzsignal wird über zwei Trennkondensatoren 40 bzw. 41 und eine integrierte Streifenleiterspule 26 sowie über eine Drahtbrücke 27 zum Zwischenfrequenzsignalausgang 3 geführt. Die Transformation des Zwischenfrequenz-Innenwiderstands auf den Wert $Z_0$ (beispielsweise 50 Ω) erfolgt ähnlich wie im Ausführungsbeispiel nach Fig. 1 mit zwei Abblockkondensatoren 30 und 31 als Parallelkapazität und der Spule 26 als Serieninduktivität. Die Drosseln 34 und 35 sind für die Zwischenfrequenz hochohmig und praktisch ohne Bedeutung. Die Zusammenschaltstelle der beiden Trennkondensatoren 40 und 41, an der die Streifenleiterspule 26 mit einem Anschluß liegt, ist mit 67 bezeichnet. Die Trennkondensatoren 40 und 41 sind jeweils mit zwei Streifenleitern 65, 65a bzw. 66, 66a mit den Drosseln 34 bzw. 35 verbunden, wobei im Verlaufe dieser beiden Streifenleiter 65, 65a bzw. 66, 66a für die Dioden 21 bzw. 22 eine Anschlußstelle 63 bzw. 64 vorgesehen ist, von welcher die leerlaufenden Streifenleiter 28 bzw. 29 und die Abblockkondensatoren 30 bzw. 31 ausgehen.

Der über der gestrichelten Linie liegende Differentialübertragerteil des Ausführungsbeispiels nach Fig. 2 ist mit zwei jeweils halbkreisförmigen Koaxialleitungen 10 und 50 ausgestattet, welche über den Streifenleitern 6 bzw. 7 angeordnet sind. Die Koaxialleitungen 10 und 50 sind mit ihren Außenleiterenden an den Enden der beiden Streifenleiter 6 bzw. 7 elektrisch und mechanisch befestigt, z. B. angelötet. Durch die besondere Formgebung und Anbringung der Koaxialleitungen 10 und 50 sind mechanische Spannungen praktisch vollständig ausgeschaltet. Die gegenüber dem Ausführungsbeispiel nach Fig. 1 neu eingeführte Koaxialleitung 50 auf dem Streifenleiter 7 ergibt den Vorteil einer noch größeren Bandbreite der Anpassung am Eingangssignalanschluß 1. Die Koaxialleitung 50 ist mit Hilfe eines an ihren Innenleiter an der Verbindungsstelle 51 angebrachten Streifenleiters 52 auf etwa eine Viertelwellenlänge ergänzt. Damit wird der Leerlauf am Ende der Leitung mit dem Streifenleiter 52 bei der Mittenfrequenz in einen Kurzschluß am Eingang der Koaxialleitung 50 bei dem Anschluß 5 transformiert, also der Innenleiter der Koaxialleitung 10 mit dem Anschluß 5 verbunden. Die Innenleiter der beiden Koaxialleitungen 10 und 50 sind miteinander verbunden. Bei Frequenzen, die von der Mittenfrequenz abweichen und bei denen die Leitungen mit den Streifenleitern 6 und 7 vom gewünschten, z. B. induktiven Blindwiderstand abweichen, erscheint am Eingang der koaxialen Leitung 50 an der Anschlußstelle 5 ein der Abweichung entgegenwirkender Blindwiderstand, dessen Größe mit dem Wellenwiderstand der koaxialen Leitung 50 einstellbar ist.

Die jeweils eine Viertelwellenlänge langen Streifen leitungen 11 und 12 zwischen dem Eingangssignalanschluß 2 und den Anschlüssen 4 bzw. 5 sind im Ausführungsbeispiel nach Fig. 2 teilweise mäandriert ausgeführt. Im übrigen stimmt das Ausführungsbeispiel nach Fig. 2 mit demjenigen nach Fig. 1 überein.

Voraussetzung für die anhand der Fig. 1 und 2 aufgezeigten Diodenschaltungen ist, daß eine gute hochfrequenzmäßige Abblockung nach den Mischerdioden 21 und 22 mittels konzentrierter Kondensatoren 24 bzw. 30 und 31, eventuell unter Zuhilfenahme der Serienresonanz, möglich ist. Bei Betriebsfrequenzen über etwa 3 GHz ist diese Möglichkeit nicht mehr ohne weiteres gegeben. Dort lassen sich beispielsweise kapazitive Streifenleiterflecke verwenden. Auch Viertelwellenlängen-Leitungsstücke, die bei der Betriebsfrequenz etwa einen Kurzschluß an die Mischerdioden 21 und 22 bringen, sind verwendbar.

In Fig. 3 ist ebenfalls in einer vergrößerten Draufsicht das Beispiel einer solchen Schaltung gezeigt. Eine abgewinkelte, eine Viertelwellenlänge lange niederohmige Streifenleitung 42 übernimmt hier die Abblockung. Eine leerlaufende Streifenleitung 28 schließt zusätzlich die Summenfrequenz der Eingangssignale kurz. Da die Kapazität der beiden Leitungen 28 und 42 aber meistens nicht ausreichen dürfte, um die erforderliche Transformation des Zwischenfrequenz-Innenwiderstands auf den Wert $Z_0$ (Beispielsweise 50 Ω) zusammen mit der Serieninduktivität der Streifenleiterspule 26 zu ermöglichen, ist deshalb im Ausführungsbeispiel nach Fig. 3 eine Zusatzkapazität 44 in Form eines diskreten, an der Stelle 45 zur Masse durchkontaktierten Kondensators vorgesehen. Zur Entkopplung von der Abblockung ist zusätzlich eine hochohmige, etwa eine Viertelwellenlänge lange Streifenleitung 43 eingefügt. Im übrigen entspricht die Gegentaktmischeranordnung nach Fig. 3 derjenigen nach Fig. 1.

**Patentansprüche**

1. Mikrowellen-Gegentaktmischerschaltung in Streifenleitungstechnik mit einem Differentialübertrager (61), der zum Anlegen zweier zu mischender Eingangsspannungen zwei Eingangsanschlüsse (1, 2) aufweist, von denen der erste (2) zur gleichphasigen Aufteilung der ihm zugeführten Eingangsspannung (HF-Eingangssignal) auf zwei Übertrager-Ausgangsanschlüsse (4, 5) über zwei Viertelwellenlängen-Streifenleitungen (11, 12) mit den beiden Übertrager-Ausgangsanschlüssen und von denen der zweite (1) zur gegenphasigen Aufteilung der ihm zugeführten Eingangsspannung (Oszillatorsignal) über geeignete Leitungsverbindungen ebenfalls mit den beiden Übertrager-Ausgangsanschlüssen (4, 5) verbunden ist, an die jeweils über einen von zwei symmetrischen Streifenleitern (17, 18) an einer verbreiterten und damit eine Parallelkapazität bildenden Anschlußstelle (19, 20) jeweils eine von zwei Halbleiterdioden (21, 22) angeschlossen ist, die mit ihrem anderen Anschluß an einer gemeinsamen, vor einem Zwischenfrequenzsignalausgang (3) liegenden Anschlußstelle (23) zusammengeschaltet sind, allerdings mit unterschiedlicher Polung zum Zwischenfrequenzsignalausgang (3) hin, vor dem im Anschluß an die gemeinsame Diodenanschlußstelle (23) noch eine Einrichtung zur Abblockung des Frequenzbereichs der beiden Eingangsspannungen vorgesehen ist, die aus Streifenleiterstücken (62, 26) und/oder konzentrierten Bauelementen besteht und so dimensioniert ist, daß sich bei der gewünschten Zwischenfrequenz am Zwischenfrequenzsignalausgang (3) ein Widerstandswert $Z_0$ ergibt, dadurch gekennzeichnet, daß die Leitungsverbindungen im Differentialübertrager zur. gegenphasigen Aufteilung der dem zweiten Eingangsanschluß (1) zugeführten Eingangsspannung so ausgebildet sind, daß der zweite Eingangsanschluß mit dem einen Übertrager-Ausgangsanschluß (5) über den Innenleiter einer bogenförmig verlaufenden, koaxialen Leitung (10) verbunden ist, zu der symmetrisch, ausgehend von diesem Übertrager-Ausgangsanschluß (5) ein bogenförmig verlaufender Streifenleiter (7) mit Durchkontaktierung (9) zur Masseplatte (70) am Ende angeordnet ist und deren eines Außenleiterende zur Masseplatte (70) durchkontaktiert (8) und deren anderes Außenleiterende am anderen Übertrager-Ausgangsanschluß (4) angeschlossen ist, daß die bogenförmige koaxiale Leitung (10) und der dazu symmetrisch verlaufende Streifenleiter (7), die von den beiden Differentialübertrager-Ausgangsanschlüssen (4 bzw. 5) abgehen, kürzer ausgebildet sind als eine Viertelwellenlänge, so daß sich Parallelinduktivitäten ergeben, daß die beiden symmetrischen Streifenleiter (17, 18) zwischen den beiden Übertrager-Ausgangsanschlüssen (4, 5) und den beiden Diodenanschlußstellen (19, 20), die verbreiterten Diodenanschlußstellen (19, 20) selbst und die bogenförmig verlaufende koaxiale Leitung (10) sowie der dazu symmetrisch bogenförmige Streifenleiter (7) des Differentialübertragers so bemessen sind, daß die Diodenimpedanzen an den Differentialübertrager-Ausgangsanschlüssen (4, 5) jeweils auf den Widerstandswert $Z_0$ transformiert werden, daß die Breite der beiden vom ersten Eingangsanschluß (2) ausgehenden Viertelwellenlängen-Streifenleiter (11, 12) des Differentialübertragers so bemessen ist, daß sich jeweils ein Wellenwiderstandswert $Z_0 \cdot \sqrt{2}$ ergibt, und daß zwischen dem den Differentialübertrager-Ausgangsanschlüssen (4, 5) abgekehrten Innenleiterende (13) der koaxialen Leitung (10) und dem zugehörigen Eingangsanschluß (1) ein Streifenleiter (14) eingefügt ist, so daß die Gesamtlänge der koaxialen Leitung (10) und dieses Streifenleiters (14) eine Viertelwellenlänge und der Wellenwiderstandswert dieser beiden Leitungen $Z_0 \cdot \sqrt{2}$ beträgt.

2. Mikrowellen-Gegentaktmischerschaltung nach Anspruch 1, dadurch gekennzeichnet, daß die koaxiale Leitung (10) räumlich über einem Streifenleiter (6) angeordnet ist und die beiden Außenleitenden der koaxialen Leitung (10) mit den Enden dieses Streifenleiters (6) elektrisch und mechanisch verbunden sind.

3. Mikrowellen-Gegentaktmischerschaltung nach Anspruch 2, dadurch gekennzeichnet, daß der Durchmesser der koaxialen Leitung (10) höchstens gleich der Breite des darunter liegenden Streifenleiters (6) ist.

4. Mikrowellen-Gegentaktmischerschaltung nach Anspruch 2, dadurch gekennzeichnet, daß bei Verwendung einer koaxialen Leitung (10), die einen die Breite des darunter verlaufenden Streifenleiters (6) übersteigenden Durchmesser aufweist, der dazu symmetrisch verlaufende Streifenleiter (7) aus Wellenwiderstandssymmetriegründen breiter ausgebildet ist.

5. Mikrowellen-Gegentaktmischerschaltung nach einem der Ansprüche 2 bis 4, dadurch gekennzeichnet, daß von den beiden Differentialübertrager-Anschlußstellen (4, 5) kleine Streifenleiterstücke (15, 16) ausgehen, die Parallelkapazitäten bilden und hinsichtlich ihrer Längen so bemessen sind, daß sich Wellenwiderstandssymmetrie der beiden geometrisch, symmetrisch und bogenförmig verlaufenden Leitungen (10, 7) ergibt.

6. Mikrowellen-Gegentaktmischerschaltung nach einem der vorhergehenden Ansprüche, dadurch gekennzeichnet, daß zwischen dem dem Zwischenfrequenzsignalausgang (3) zugekehrten Diodenanschluß (23) und dem Zwischenfrequenzsignalausgangsanschluß (3) eine als spiralförmige integrierte Streifenleiterspule (26) ausgebildete Induktivität zwischengeschaltet und an diesem Diodenanschluß (23) ein mit seinem anderen Ende (25) an Masse (70) durchkontaktierter Abblockkondensator (24) angeschlossen ist, daß die Transformation des Zwischenfrequenzinnenwiderstands auf den Widerstandswert $Z_0$ am Zwischenfrequenzsignalausgang (3) durch passende Bemessung des Abblockkondensators (24) und der Spule (26) erfolgt und daß der sich aus der Kapazität und der Zuleitungsinduktivität des Abblockkondensators (24) zusammensetzende Serienresonanzkreis hinsichtlich seiner Resonanzfrequenz in der Gegend der Frequenzen der beiden Eingangsspannungen liegt.

7. Mikrowellen-Gegentaktmischerschaltung nach Anspruch 6, dadurch gekennzeichnet, daß der Abstand zwischen dem gemeinsamen Diodenanschluß (23) und der Durchkontaktierungsstelle (25) für die Bemessung der Zuleitungsinduktivität und damit der gewünschten Serienresonanzerzeugung geeignet gewählt ist.

8. Mikrowellen-Gegentaktmischerschaltung nach einem der vorhergehenden Ansprüche, dadurch gekennzeichnet, daß von dem dem Zwischenfrequenzsignalausgang (3) zugekehrten Diodenanschluß (23) ein am Ende leerlaufender Streifenleiter (28) ausgeht, der ein Viertel von derjenigen Wellenlänge lang ist, die der Summenfrequenz der beiden Eingangsspannungen entspricht.

9. Mikrowellen-Gegentaktmischerschaltung nach einem der vorhergehenden Ansprüche, dadurch gekennzeichnet, daß zu jeder der beiden Dioden (21, 22) in Richtung zum Zwischenfrequenzsignalausgang (3) ein Trennkondensator (40, 41) mittels eines Streifenleitungszuges (65, 66) in Reihe geschaltet ist und daß von den beiden sich jeweils zwischen einer Diode (21, 22) und einem zugeordnetem Trennkondensator (40, 41) befindlichen Schaltungsstellen (63, 64) zu zwei äußeren Anschlußstellen (36, 37), jeweils ein Leitungszug (65a, 66a) ausgeht (Fig. 2).

10. Mikrowellen-Gegentaktmischerschaltung nach Anspruch 9, dadurch gekennzeichnet, daß in jedem der beiden zu den äußeren Anschlußstellen (36, 37) führenden Leitungszüge (65a, 66a) eine Drossel (34, 35) als Längsglied angeordnet ist (Fig. 2).

11. Mikrowellen-Gegentaktmischerschaltung nach Anspruch 9 und 10, dadurch gekennzeichnet, daß parallel zu jedem der beiden Leitungszüge (65a, 66a) ein Abblockkondensator (30, 31) und ein Widerstand (38, 39) in Reihe zueinander angeordnet sind, daß dazwischen eine Durchkontaktierung (32, 33) zur Masseplatte (70) vorgesehen ist, daß zwischen derjenigen Schaltungsstelle (67), die sich zwischen den beiden Trennkondensatoren (40, 41) befindet, und dem Zwischenfrequenzsignalausgang (3) eine als spiralförmige integrierte Streifenleiterspule (26) ausgebildete Induktivität zwischengeschaltet ist und daß die Transformation des Zwischenfrequenz-Innenwiderstands auf den Widerstandwert $Z_0$ am Zwischenfrequenzsignalausgang (3) durch passende Bemessung der Abblockkondensatoren (30, 31) und der Streifenleiterspule (26) erfolgt (Fig. 2).

12. Mikrowellen-Gegentaktmischerschaltung nach den Ansprüche 9 bis 11, dadurch gekennzeichnet, daß von den sich jeweils zwischen einer Diode (21, 22) und einem Trennkondensator (40, 41) befindlichen Schaltungsstellen (63, 64) jeweils ein am Ende leerlaufender Streifenleiter (28, 29) ausgeht, der ein Viertel von derjenigen Wellenlänge lang ist, die der Summenfrequenz der beiden Eingangsspannungen entspricht (Fig. 2).

13. Mikrowellen-Gegentaktmischerschaltung nach einem der vorhergehenden Ansprüche, dadurch gekennzeichnet, daß über dem symmetrisch zur koaxialen Leitung (10) verlaufenden Streifenleiter (7) des Differential-Übertragers (61) eine zweite koaxiale Leitung (50) angeordnet ist, deren eines Innenleiterende mit dem Innenleiter der ersten koaxialen Leitung (10) verbunden ist und an deren anderes Innenleiterende (51) ein leerlaufender Streifenleiter (52) angefügt ist, so daß die Gesamtlänge der zweiten Koaxialleitung (50) und des daran angefügten Streifenleiters (52) etwa eine Viertelwellenlänge der Eingangsspannungen beträgt (Fig. 2).

14. Mikrowellen-Gegentaktmischerschaltung nach Anspruch 13, dadurch gekennzeichnet, daß die zweite koaxiale Leitung (50) an ihren beiden Außenleiterenden elektrisch und mechanisch mit dem darunter liegenden Streifenleiter (7) verbunden ist.

15. Mikrowellen-Gegentaktmischerschaltung nach einem der Ansprüche 13 und 14, dadurch gekennzeichnet, daß die beiden koaxialen Leitungen (10, 50) jeweils in einem halbkreisförmigen Bogen angeordnet sind.

16. Mikrowellen-Gegentaktmischerschaltung nach einem des vorhergehenden Ansprüche, dadurch gekennzeichnet, daß diejenige Eingangsspannung, die an dem zur ersten koaxialen Leitung (10) führenden Streifenleiter (14) anliegt, ein Oszillatorsignal und diejenige Eingangsspannung, die an dem mit den beiden Viertelwellenlängen-Streifenleitungen (11, 12) verbundenen Eingangsanschluß (2) liegt, ein herunterzumischendes Hochfrequenz-Eingangssignal ist.

**Claims**

1. A microwave balanced mixer circuit using microstrip transmission lines, with a differential transformer (61) for the connection of two input voltages which are to be mixed, having two input terminals (1, 2), of which the first (2), for the equal-phased distribution of the supplied input voltage (HF-input signal) between two transformer output terminals (4, 5), is connected via two quarter-wavelength microstrip transmission lines (11, 12) to the two transformer output terminals, and of which the second (1), for the phase-opposing distribution of its supplied input voltage (oscillator signal) is connected via suitable line connections to the two transformer output terminals (4, 5), each of which is connected via one of two symmetrical microstrip transmission lines (17, 18), at a widened connection point (19, 20) forming a parallel capacitance, to one of two semiconductor diodes (21, 22) which are interconnected by their other terminal at a common connection point (23) which precedes an intermediate frequency signal output (3), but with different polarity in the direction of the intermediate frequency signal output (3), prior to which there is arranged adjoining the common diode connection point (23) a device which serves to block the frequency range of the two input voltages and which consists of portions of microstrip transmission lines (62, 26) and/or lumped components and is dimensioned in such manner that at the desired intermediate frequency there is presented an impedance value $Z_0$ at the intermediate frequency signal output (3) characterised in that the transmission line connection in the differential transformer for the phase-opposing distribution of the input voltage supplied to the second input terminal (1) are designed such that the second input terminal is connected to the first transformer output terminal (5) via the inner conductor of a curved coaxial transmission line (10) and commencing from this transformer output terminal (5) there is symmetrically arranged a curved microstrip transmission line (7) with a through-contact (9) to the earth plate (70) at its end, the coaxial line outer conductor being through-contacted to the earth plate (70) at one end, and connected to the other transformer output terminal (4) at its other end, that the curved coaxial transmission line (10) and the microstrip transmission line (7) symmetrical thereto, which emanate from the two differential transformer output terminals (4, 5) are shorter than a quarter-wavelength, so that parallel inductances are presented, that the two symmetrical microstrip transmission lines (17, 18) between the two transformer output terminals (4, 5) and the two diode connection points (19, 20), the widened diode connection points themselves (19, 20), and the curved coaxial transmission line (10) together with the curved microstrip transmission line (7) symmetrical thereto in the differential transformer are contrived to be such that the diode impedances across the differential transformer output terminals (4, 5) are each transformed to the impedance value $Z_0$, that the width of the two quarter-wavelength microstrip transmission lines (11, 12) which emanate from the first input terminal (2) of the differential transformer are contrived to be such that in each case there is a surge impedance value $Z_0 \cdot \sqrt{2}$, and that between the inner conductor end (13) of the coaxial transmission line (10) remote from the differential transformer output terminals (4, 5) and the associated input terminal (1) there is interposed a microstrip transmission line (14) so that the overall length of the coaxial transmission line (10) and this microstrip transmission line (14) amounts to a quarter-wavelength and the surge impedance value of these two transmission lines amounts to $Z_0 \cdot \sqrt{2}$.

2. A microwave balanced mixer circuit as claimed in Claim 1, characterised in that the coaxial transmission line (10) is arranged above a microstrip transmission line (6), and the two ends of the outer conductor of the coaxial transmission line (10) are electrically and mechanically connected to the ends of this microstrip transmission line (6).

3. A microwave balanced mixer circuit as claimed in Claim 2, characterised in that the diameter of the coaxial transmission line (10) is at the maximum equal to the width of the underlying microstrip transmission line (6).

4. A microwave balanced mixer circuit as claimed in Claim 2, characterised in that if the coaxial transmission line (10) used has a diameter which exceeds the width of the underlying microstrip transmission line (6), the microstrip transmission line (7) which is symmetrical thereto is designed to be wider to provide surge impedance symmetry.

5. A microwave balanced mixer circuit as claimed in one of Claims 2 to 4, characterised in that from the two differential transformer connection points (4, 5) there emanate small portions of microstrip transmission lines (15, 16) which form parallel capacitances and whose lengths are contrived to be such that there is surge impedance symmetry between the two transmission lines (10, 7) which run geometrically symmetrically in curved fashion.

6. A microwave balanced mixer circuit as claimed in one of the preceding Claims, characterised in that in the connection between the diode terminal (23) adjacent the intermediate frequency signal output (3) and the intermediate frequency signal output terminal (3) there is connected an inductance in the form of a spiral integrated microstrip coil (26), and this diode terminal (23) is connected to a decoupling capacitor (24) whose other end (25) is through-contacted to earth (70), that the transformation of the intermediate frequency internal impedance to the impedance value $Z_0$ at the intermediate frequency signal output (3) is effected by suitable dimensioning of the decoupling capacitor (24) and the coil (26), and that the resonant frequency of the series resonant circuit composed of the capacitance and the supply inductance of the decoupling capacitor (24) lies in the region of the frequencies of the two input voltages.

7. A microwave balanced mixer circuit as claimed in Claim 6, characterised in that the interval between the common diode terminal (23) and the through-contacting point (25) is selected to be suitable for the dimensioning of the supply inductance and thus the generation of the desired series resonance.

8. A microwave balanced mixer circuit as claimed in one of the preceding Claims, characterised in that from the diode terminal (23) adjacent the intermediate frequency signal output (3) there extends a microstrip transmission line (28) which has no load at its end and whose length is a quarter of the wavelength which corresponds to the sum frequency of the two input voltages.

9. A microwave balanced mixer circuit as claimed in one of the preceding Claims, characterised in that in the direction of the intermediate frequency signal output (3) each of the two diodes (21, 22) is connected in series with an isolating capacitor (40, 41) via a microstrip transmission line (65, 66), and that a transmission line (65a, 66a) leads from the two circuit points (63, 64), located between a diode (21, 22) and its assigned isolating capacitor (40, 41), to two external connection points (36, 37) (Fig. 2).

10. A microwave balanced mixer circuit as claimed in Claim 9, characterised in that a choke (34, 35) is arranged as a series element in each of the two transmission lines (65a, 66a) which lead to the external connection points (36, 37) (Fig. 2).

11. A microwave balanced mixer circuit as claimed in Claims 9 and 10, characterised in that a decoupling capacitor (30, 31) and an impedance (38, 39) are arranged in series with one another parallel to each of the two transmission lines (65a, 66a) that an intermediate through-contact (32, 33) to the earth plate (70) is provided, that between that circuit point (67) located between the two isolating capacitors (40, 41), and the intermediate frequency signal output (3) there is connected an inductance designed as a spiral integrated microstrip coil (26), and that the transformation of the intermediate frequency internal impedance to the impedance value $Z_0$ at the intermediate frequency signal output (3) is effected by suitable dimensioning of the decoupling capacitors (30, 31) and the microstrip coil (26) (Fig. 2).

12. A microwave balanced mixer circuit as claimed in Claims 9 to 11, characterised in that a microstrip transmission line (28, 29) which has no load at its end and which has a length of one quarter of the wavelength which corresponds to the sum frequency of the two input voltages extends from the circuit points (63, 64), which are located between a diode (21, 22) and its isolating capacitor (40, 41) (Fig. 2).

13. A microwave balanced mixer circuit as claimed in one of the preceding Claims, characterised in that above the microstrip transmission line (7) symmetrical to the coaxial transmission line (10) in the differential transformer (61) there is arranged a second coaxial transmission line (50) whose inner conductor end is connected at one end to the inner conductor of the first coaxial transmission line (10), and whose other inner conductor end (51) is attached to a microstrip transmission line (52) which has no load, so that the overall length of the second coaxial transmission line (50) and the microstrip transmission line (52) attached thereto amounts to approximately a quarter-wavelength of the input voltages (Fig. 2).

14. A microwave balanced mixer circuit as claimed in Claim 13, characterised in that the second coaxial transmission line (50) has its two outer conductor ends electrically and mechanically connected to the underlying microstrip transmission line (7).

15. A microwave balanced mixer circuit as claimed in one of Claims 13 and 14, characterised in that the two coaxial transmission lines (10, 50) are each arranged on a semicircular curve.

16. A microwave balanced mixer circuit as claimed in one of the preceding Claims, characterised in that the input voltage applied to the microstrip transmission line (14) which leads to the first coaxial transmission line (10) is an oscillator signal, and the input voltage applied to the input terminal (2) connected to the two quarter-wavelength microstrip transmission lines (11, 12) is a high-frequency input signal which is to be reduced in frequency.

**Revendications**

1. Circuit mélangeur symétrique à micro-ondes réalisé suivant la technique des conducteurs en micro-bandes, comportant un transformateur différentiel (61), qui comporte, pour l'application de deux tensions d'entrée devant être mélangées, deux bornes d'entrée (1, 2) dont la première (2) est reliée, en vue de la répartition en phase de la tension d'entrée (signal d'entrée à haute fréquence), qui lui est envoyée, entre deux bornes de sortie (4, 5) du transformateur par l'intermédiaire de deux lignes en forme de bandes quart-d'onde (11, 12), aux deux bornes de sortie du transformateur et dont la seconde (1) est également reliée, pour la répartition en opposition de phase de la tension d'entrée (signal d'oscillateur), qui lui est envoyée, par l'intermédiaire de lignes de liaison appropriées, aux deux bornes de sortie (4, 5) du transformateur, auxquelles sont raccordées, par l'intermédiaire de deux conducteurs en micro-bandes symétriques respectives (17, 18), en des points de raccordement (19, 20) élargis et formant par conséquent une capacité parallèle, respectivement deux diodes semiconductrices (21, 22) qui sont interconnectées par leur autre borne à un point de raccordement commun (23) situé en amont d'une sortie (3) de signaux à fréquence intermédiaire, et ce, assurément, avec une polarité différente en direction de ladite sortie (3) de signaux à fréquence intermédiaire, en amont de laquelle se trouve encore prévu, à la suite du point commun (23) de raccordement des diodes un dispositif servant à bloquer la plage des fréquences des deux tensions d'entrée et qui est constitué par des éléments conducteurs en micro-bandes (62, 26) et/ou par des composants concentrés et est dimensionné de telle sorte que l'on obtient une valeur de résistance $Z_0$ à la sortie (3) des signaux à fréquence intermédiaire, pour la fréquence intermédiaire désirée, caractérisé par le fait que les lignes de liaison présentes dans le transformateur différentiel pour réaliser la répartition en opposition de la phase de la tension d'entrée envoyée à la seconde borne d'entrée (1) sont réalisées de telle manière que la seconde borne d'entrée est reliée à une borne de sortie (5) du transformateur par l'intermédiaire du conducteur intérieur d'une ligne coaxiale (10) en forme d'arc de cercle, qu'un conducteur en micro-bande (7) s'étendant suivant un arc de cercle et comportant, sur son extrémité, un contact le traversant (9) aboutissant à la plaque de masse (70) est disposé symétriquement par rapport à ladite ligne, à partir de cette borne de sortie (5) du transformateur et qu'une extrémité du conducteur extérieur de cette ligne est interconnectée par un contact traversant (8) à la plaque de masse (70) et que l'autre extrémité de ce conducteur extérieur est raccordée à l'autre borne de sortie (4) du transformateur, que la ligne coaxiale (10) en forme d'arc de cercle et le conducteur en micro-bande (7) symétrique de ladite ligne, qui partent des deux bornes de sortie (4 et 5) du transformateur différentiel, sont réalisées en étant plus courtes que le quart de la longueur d'onde de sorte qu'il apparaît des inductances parallèles, que les deux conducteurs en micro-bandes symétriques (17, 18) situées entre les deux bornes de sortie (4, 5) du transformateur et les deux points (19, 20) de raccordement des diodes, ces points (19, 20) élargis de raccordement des diodes eux-mêmes et la ligne coaxiale en forme d'arc de cercle (10) ainsi que le conducteur en micro-bande (7), s'étendant suivant un arc de cercle et disposé symétriquement par rapport à ladite ligne, du transformateur différentiel sont dimensionnés de telle manière que les impédances des diodes au niveau des bornes de sortie (4, 5) du transformateur différentiel sont transformées en la valeur de résistance $Z_0$, que la largeur des deux conducteurs en micro-bande quart-d'onde du transformateur différentiel, partant de la première borne d'entrée (2), sont dimensionnés de telle sorte que l'on obtient une impédance caractéristique $Z_0 \cdot \sqrt{2}$, et qu'un conducteur en micro-bande (14) est inséré entre l'extrémité (13) du conducteur intérieur, tournée à l'opposé des bornes de sortie (4, 5) du transformateur différentiel, de la ligne coaxiale (10) et la borne d'entrée associée (1) de telle sorte que la longueur totale de la ligne coaxiale (10) et de ce conducteur en micro-bande (14) est égale au quart de la longueur d'onde et que la valeur de l'impédance caractéristique de ces deux lignes est égale à $Z_0 \cdot \sqrt{2}$.

2. Circuit mélangeur symétrique à micro-ondes suivant la revendication 1, caractérisé par le fait que la ligne coaxiale (10) est disposée dans l'espace au-dessus d'un conducteur en micro-bande (6) et que les deux extrémités du conducteur extérieur de la ligne coaxiale (10) sont reliées électriquement et mécaniquement aux extrémités de ce conducteur en forme de bande (6).

3. Circuit mélangeur symétrique à micro-ondes suivant la revendication 2, caractérisé par le fait que le diamètre de la ligne coaxiale (10) est égal au maximum à la largeur du conducteur en micro-bande sous-jacent (6).

4. Circuit mélangeur symétrique à micro-ondes suivant la revendication 2, caractérisé par le fait que dans le cas d'utilisation d'une ligne coaxiale (10), qui possède un diamètre supérieur à la largeur du conducteur en micro-bande (6) sous-jacent, le conducteur en micro-bande (7) disposé symétriquement par rapport à ladite ligne est réalisé avec une largeur supérieure pour des questions de symétrie de l'impédance caractéristique.

5. Circuit mélangeur symétrique à micro-ondes suivant l'une des revendications 2 à 4, caractérisé par le fait qu'à partir des deux bornes de raccordement (4, 5) du transformateur différentiel s'étendent de petits éléments conducteurs en micro-bandes (15, 16) qui forment des capacités parallèles et dont les longueurs sont dimensionnées de manière à obtenir une symétrie de l'impédance caractéristique des deux lignes (10, 7) disposées géométriquement sous la forme d'arcs de cercle symétriques.

6. Circuit mélangeur symétrique à micro-ondes suivant l'une des revendications précédentes, caractérisé par le fait qu'une inductance réalisée sous la forme d'une bobine de conducteur en micro-bande (26) intégrée et réalisée sous une forme spiralée est interconnectée entre la borne (23) de la diode, tournée vers la sortie (3) des signaux à fréquence intermédiaire, et la borne (3) de sortie des signaux à fréquence intermédiaire, et qu'un condensateur de blocage (24), dont l'autre extrémité (25) est raccordée par un contact traversant à la masse (70), est raccordé à cette borne (23) de la diode, que la transformation de la résistance intérieure à fréquence intermédiaire, l'amenant à la valeur de résistance $Z_0$ à la sortie (3) des signaux à fréquence intermédiaire est obtenue grâce à un dimensionnement adapté du condensateur blocage (24) et de la bobine (26) et que la fréquence de résonance du circuit résonnant série, constituée par la capacité et par l'inductance de la ligne d'alimentation du condensateur de blocage (24) se situe dans la plage des fréquences des deux tensions d'entrée.

7. Circuit mélangeur symétrique à micro-ondes suivant la revendication 6, caractérisé par le fait que la distance entre la borne commune (23) de la diode et le point (25) du contact traversant est choisie de façon appropriée pour le dimensionnement de l'inductance de la ligne d'alimentation et par conséquent pour la production désirée de la résonance série.

8. Circuit mélangeur symétrique à micro-ondes suivant l'une des revendications précédentes, caractérisé par le fait qu'à partir de la borne (23) de la diode, tournée vers la sortie (3) des signaux de fréquence intermédiaire, s'étend un conducteur en micro-bande (28) dont l'extrémité est en circuit ouvert et qui possède une longueur égale au quart de la longueur d'onde qui correspond à la fréquence somme des deux tensions d'entrée.

9. Circuit mélangeur symétrique à micro-ondes suivant l'une des revendications précédentes, caractérisé par le fait qu'un condensateur de séparation (40, 41) est branché en série avec chacune des deux diodes (21, 22) situées sur le trajet aboutissant à la sortie (3) des signaux à fréquence intermédiaire, au moyen d'un tracé de ligne en micro-bandes (65, 66), et qu'un tracé de ligne (65a, 66a) par des deux points de circuit (63, 64), situés respectivement entre une diode (21, 22) et un condensateur associé de séparation (48, 41), en direction de deux points extérieurs de raccordement (36, 37) (figure 2).

10. Circuit mélangeur symétrique à micro-ondes suivant la revendication 9, caractérisé par le fait qu'une bobine d'arrêt (34, 35) est disposée en tant qu'élément longitudinal dans chacun des deux tracés de lignes (65a, 66a) aboutissant aux points extérieurs de raccordement (36, 37) (figure 2).

11. Circuit mélangeur symétrique à micro-ondes suivant les revendications 9 et 10, caractérisé par le fait qu'un condensateur blocage (30, 31) et une résistance (38, 39) sont branchés réciproquement en série, et ce en parallèle avec chacun des deux tracés de lignes (65a, 66a), et qu'un contact traversant (32, 33) aboutissant à la plaque de masse (70) est prévu entre ce condensateur et cette résistance, qu'une inductance réalisée sous la forme d'une bobine conducteur en micro-bande (26) intégrée et de forme spiralée est interconnectée entre le point de circuit (67), qui est situé entre les deux condensateurs de séparation (40, 41), et la sortie (3) des signaux à fréquence intermédiaire, et que la transformation de la résistance intérieure à fréquence intermédiaire en la valeur de résistance $Z_0$ est réalisée, au niveau de la sortie (3) des signaux à fréquence intermédiaire, grâce à un dimensionnement adapté des condensateurs de blocage (30, 31) et de la bobine du conducteur en micro-bande (26) (figure 2).

12. Circuit mélangeur symétrique à micro-ondes suivant les revendications 9 à 11, caractérisé par le fait qu'à partir des points de circuit (63, 64) situés respectivement entre les diodes (21, 22) et les condensateurs de séparation (40, 41) s'étendent des conducteurs en micro-bandes (28, 29) dont l'extrémité est en circuit ouvert et qui possèdent une longueur égale au quart de la longueur d'onde qui correspond à la fréquence somme des deux tensions d'entrée (figure 2).

13. Circuit mélangeur symétrique à micro-ondes suivant l'une des revendications précédentes, caractérisé par le fait qu'au-dessus du conducteur en micro-bande (7), qui s'étend symétriquement par rapport à la ligne coaxiale (10), du transformateur différentiel (61) se trouve disposée une seconde ligne coaxiale (50) dont l'extrémité du conducteur intérieur est reliée au conducteur intérieur de la première ligne coaxiale (10), et au niveau de l'autre extrémité (51) du conducteur intérieur de laquelle est raccordé un conducteur en micro-bande (52), qui est en circuit ouvert, de telle sorte que la longueur totale de la seconde ligne coaxiale (50) et du conducteur en micro-bande (52), qui y est raccordé, est égale au quart de la longueur d'onde des tensions d'entrée (figure 2).

14. Circuit mélangeur symétrique à micro-ondes suivant la revendication 13, caractérisé par le fait que la seconde ligne coaxiale (50) est reliée électriquement et mécaniquement, au niveau des deux extrémités de son conducteur extérieur, au conducteur en micro-bande sous-jacent (7).

15. Circuit mélangeur symétrique à micro-ondes suivant l'une des revendications 13 et 14, caractérisé par le fait que les deux lignes coaxiales (10, 50) sont disposées respectivement suivant un arc en forme de demi-cercle.

16. Circuit mélangeur symétrique à micro-ondes suivant l'une des revendications précédentes, caractérisé par le fait que la tension d'entrée, qui est appliquée au conducteur en micro-bande (14) aboutissant à la première ligne coaxiale (10), est un signal d'oscillateur et que la tension d'entrée, qui est appliquée à la borne d'entrée (2) reliée aux deux conducteurs en micro-bandes (11, 12) quart-d'onde, est un signal d'entrée à haute fréquence devant être mélangé avec réduction de sa fréquence.

# FIG 1

# FIG 2

# FIG 3